Europäisches Patentamt

European Patent Office

Office européen des brevets

(19)

(11) **EP 0 720 292 B1**

(12) **FASCICULE DE BREVET EUROPEEN**

(45) Date de publication et mention
de la délivrance du brevet:
**29.03.2000 Bulletin 2000/13**

(51) Int Cl.⁷: **H03K 17/687**, H03K 17/693,
H04B 1/38, H04B 1/44

(21) Numéro de dépôt: **95203549.1**

(22) Date de dépôt: **19.12.1995**

(54) **Dispositif terminal mobile pour télécommunication incluant un circuit commutateur**

Mobilfunkendgerät mit einem Schaltkreis

Terminal device for mobile telecommunications including a switching circuit

(84) Etats contractants désignés:
**DE FR GB**

(30) Priorité: **29.12.1994 FR 9415873**

(43) Date de publication de la demande:
**03.07.1996 Bulletin 1996/27**

(73) Titulaire: **Koninklijke Philips Electronics N.V.
5621 BA Eindhoven (NL)**

(72) Inventeurs:
• **Caglio, Nathalie, Société Civile S.P.I.D.
F-75008 Paris (FR)**

• **Meignant, Didier, Société Civile S.P.I.D.
F-75008 Paris (FR)**

(74) Mandataire: **Lottin, Claudine et al
Société Civile S.P.I.D.
156, Boulevard Haussmann
75008 Paris (FR)**

(56) Documents cités:
**EP-A- 0 625 831          DE-A- 4 307 164
DE-A- 4 343 719          US-A- 5 218 285**

• **PATENT ABSTRACTS OF JAPAN vol. 17 no. 629
(E-1462) ,19 Novembre 1993 & JP-A-05 199094
(SHARP CORP.) 6 Août 1993,**

## Description

L'invention concerne un dispositif terminal mobile pour télécommunication comprenant:

une antenne d'émission-réception,
une partie pour l'émission de données, incluant un circuit amplificateur émetteur ayant une première tension de polarisation et fournissant un premier signal alternatif à un pôle d'entrée,
une partie pour la réception de données, incluant un circuit amplificateur récepteur ayant une seconde tension de polarisation pulsée multiplexée dans le temps avec la première tension de polarisation et recevant un second signal alternatif d'un pôle de sortie,
un circuit commutateur comprenant un premier et un second transistors à effet de champ montés en interrupteurs et disposés en série entre ledit pôle d'entrée et ledit pôle de sortie, et ayant un pôle commun connecté à l'antenne.

L'invention trouve son application dans le domaine des télécommunications, dans les appareils portables.

Un circuit commutateur est déjà connu du brevet des Etats-Unis US 4 810 911 (Noguchi). Ce document décrit un circuit commutateur comprenant un pôle commun d'entrée-sortie, deux pôles de commutation d'entrée-sortie, deux transistors à effet de champ respectivement montés en série entre le pôle commun d'entrée-sortie et les deux pôles de commutation d'entrée-sortie. Ce circuit comprend en outre des transistors respectivement insérés entre les deux pôles de commutation d'entrée-sortie et la masse, et des résistances respectivement insérées entre la masse et le pôle commun d'entrée-sortie, et entre la masse et les deux pôles de commutation d'entrée-sortie. Ces résistances sont choisies pour avoir une valeur de résistance plus petite que celle des transistors à effet de champ montés en shunt, lorsque ces derniers sont non-passants (OFF state).

Ce circuit est constitué de transistors à effet de champ du type MESFET qui ont une tension de seuil négative et qui sont rendus non-passants en appliquant une tension de commande plus négative que la tension de seuil, sur la grille.

La commande de ces transistors nécessite donc l'utilisation d'au moins une tension d'alimentation négative. Ceci est un inconvénient dans le cas où le circuit est inclus dans un appareil portable alimenté par des batteries fournissant seulement une tension continue positive.

Ensuite, dans ce circuit connu, les deux transistors montés en série entre le pôle commun et les deux pôles d'entrée-sortie sont des interrupteurs commandés l'un par une première tension continue négative $V_{G1}$, l'autre par une seconde tension continue négative $V_{G2}$. L'utilisation de plus d'une tension d'alimentation négative est alors un inconvénient encore plus grand dans le cas où le circuit est inclus dans un appareil portable alimenté par batteries fournissant une seule tension continue positive.

De plus, dans ce circuit connu, ces tensions continues négatives ont des valeurs appropriées pour que le premier transistor monté en série soit passant (interrupteur fermé) exactement dans le même temps où le second transistor monté en série est non-passant (interrupteur ouvert). Ceci est un inconvénient dans le cas où le circuit est utilisé dans un appareil de télécommunication mobile, car cela ne permet pas à plusieurs utilisateurs en relation avec une borne (ou base) de se partager un intervalle de temps donné pour émettre et/ou recevoir de façon concomitante.

Le problème technique que se propose de résoudre l'objet de la présente invention est exposé ci-après.

Un circuit commutateur ayant un pôle commun d'entrée-sortie par exemple relié à une antenne, et ayant deux autres pôles, l'un pour l'entrée d'un signal alternatif provenant d'un émetteur et se propageant vers l'antenne, et l'autre pour la sortie vers un récepteur d'un signal de l'antenne, doit, pour être utilisé dans un dispositif terminal mobile:

■ d'abord, comporter un interrupteur sur la branche d'émission et un interrupteur sur la branche de réception, ces interrupteurs étant commandés de telle sorte que l'émission et la réception n'aient pas lieu en même temps, ce qui conduirait à des pertes,

■ ensuite, comporter des moyens de commande de ces interrupteurs pour qu'ils ne fonctionnent pas exactement en opposition de phase, comme connu du document cité, mais pour générer un écart de temps dans le fonctionnement émission-réception et pour gérer ce fonctionnement émission-réception dans un rapport cyclique entre une longueur d'impulsion pendant laquelle peut avoir lieu une émission ou une réception, une fréquence à laquelle les impulsions se reproduisent, et un écart de temps entre une impulsion d'émission et une impulsion de réception : la détermination du rapport longueur d'impulsion et fréquence, et la détermination de l'écart entre les impulsions d'émission et réception permettent à une base de télécommunication de gérer la commutation entre plusieurs lignes, pour permettre à plusieurs utilisateurs d'émettre ou recevoir de façon concomitante à une même fréquence ;

■ comporter des moyens pour pouvoir utiliser directement une tension d'alimentation positive fournie par des batteries,

■ en outre, comporter des moyens pour économiser l'énergie consommée par le dispositif terminal mobile, pour que ce dernier puisse être utilisé en fonctionnement sur batteries,

■ et par ailleurs être compact, comporter peu d'éléments, et utiliser un nombre aussi faible que possible de niveaux de tensions continues de polarisation.

Ces problèmes sont résolus dans un dispositif tel que décrit dans la partie introductive et qui comprend en outre :

un circuit logique OU formé d'une première et d'une seconde diodes ayant un pôle commun, relié à la masse à travers une résistance, lesdites diodes recevant respectivement la première et la seconde tensions de polarisation multiplexées, circuit logique dans lequel, aux bornes de ces diodes, sont prélevées respectivement une première et une seconde différences de potentiel multiplexées, appliquées entre les électrodes de commande des premier et second transistors interrupteurs et le pôle commun à l'antenne à travers des résistances de polarisation, pour rendre passant le premier transistor interrupteur et en même temps non-passant le second transistor interrupteur, ou vice versa.

Un tel dispositif terminal mobile de télécommunication permet à plusieurs utilisateurs d'utiliser une même base (borne) en même temps.

Dans une réalisation particulière, ce dispositif comprend des capacités d'isolation en continu montées entre l'antenne et le pôle commun aux transistors interrupteurs, et entre les pôles d'entrée et sortie des amplificateurs respectivement d'émission et réception et le circuit commutateur, pour rendre ce circuit commutateur flottant vis-à-vis de la masse.

Dans un tel circuit flottant, les transistors de type MESFET sont commandés par des tensions négatives, le circuit lui-même recevant la tension continue d'alimentation positive produite par des batteries standards.

L'invention est décrite ci-après en détail en référence avec les figures schématiques annexées dont :

- la FIG.1A qui représente un circuit logique OU ;
- la FIG.1B qui représente une première mise en oeuvre d'un circuit commutateur à commande d'émission et de réception décalées cycliquement,
- la FIG.2 qui montre un chronogramme représentant les tensions de polarisation pulsées des amplificateurs émetteur et récepteur,
- les FIGS.3A, 3B, 3C qui représentent une seconde mise en oeuvre d'un circuit commutateur à commande d'émission et de réception décalées cycliquement avec deux variantes,
- la FIG.4 qui représente un dispositif mobile incluant le circuit des FIGS.1B, ou 3A à 3C.

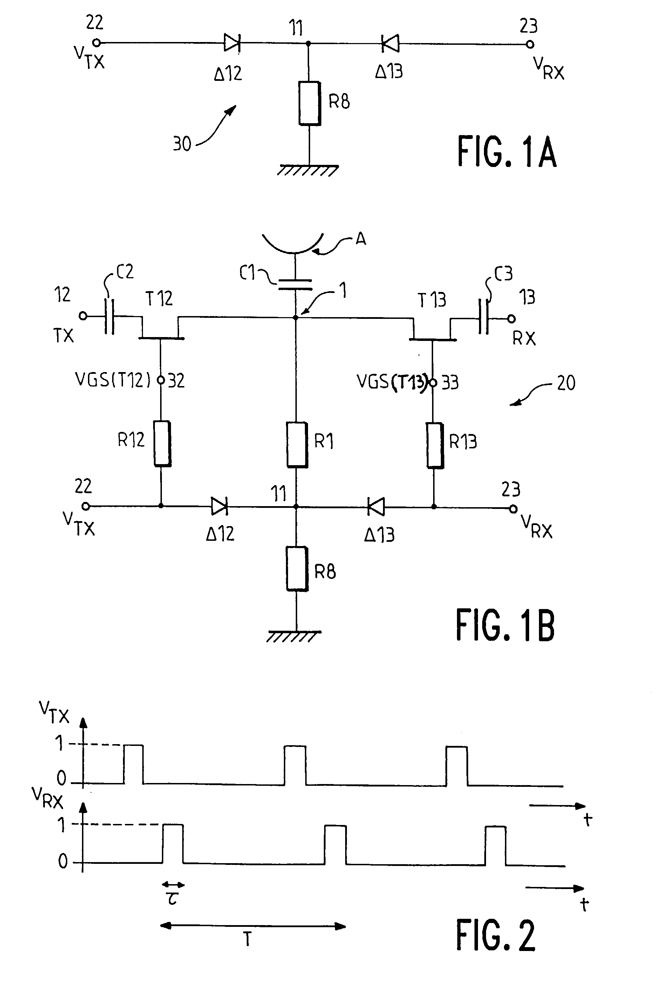

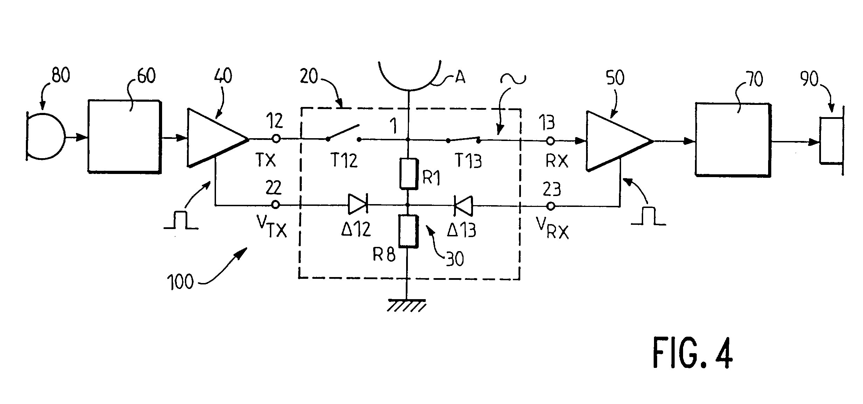

En référence avec les FIGS. 1B et 4, un appareil terminal mobile d'émission et réception, incluant un circuit commutateur (20), pour l'application aux télécommunications, comprend basiquement :

- un pôle 1 référencé premier pôle commun, pour l'entrée ou la sortie d'un signal alternatif. Dans l'exemple décrit ci-après, ce premier pôle d'entrée-sortie est relié à une antenne A d'une part, et d'autre part est polarisé en continu à travers une résistance R1 par une première tension de polarisation en continu $V_D$.
- un second pôle 12 d'entrée, réservé à l'entrée d'un signal alternatif TX provenant d'un circuit émetteur 80, 60, 40 et se propageant vers l'antenne A,
- un troisième pôle 13 de sortie, réservé à la sortie d'un signal alternatif RX provenant de l'antenne et se propageant via ce pôle 13 vers un circuit récepteur 50, 70, 90,
- un transistor à effet de champ T12, travaillant en interrupteur, monté en série entre le premier pôle commun 1 et le pôle d'entrée 12 du signal d'émission TX,
- un transistor à effet de champ T13, travaillant en interrupteur, monté en série entre le pôle commun 1 et le premier pôle de sortie 13 du signal de réception RX,
- un signal de commande $V_{GS(T12)}$ appliqué entre la grille et la source du transistor à effet de champ T12 pour le rendre passant ou non-passant : lorsque le transistor T12 est passant, le signal TX se propage du pôle d'entrée 12 vers l'antenne A.
- un signal de commande $V_{GS(T13)}$ appliqué entre la grille et la source du transistor à effet de champ T13 pour le rendre passant ou non-passant : lorsque le transistor T13 est passant, le signal RX se propage du premier pôle commun 1 (relié à l'antenne A) vers le pôle de sortie 13.

Pour éviter les pertes de signal, le transistor T13 monté en interrupteur doit être non-passant quand le transistor T12 monté en interrupteur est passant. Ainsi, soit un signal TX entre au pôle 12 et se propage vers l'antenne A, soit un signal RX provient de l'antenne A et sort au pôle 13, mais les signaux TX et RX ne se propagent pas au même instant.

De plus, dans le domaine des télécommunications, une base de gestion des commutations des lignes doit pouvoir gérer 8 lignes ou utilisateurs émettant ou recevant à la même fréquence de façon concomitante au moyen d'un dispositif terminal utilisant un tel circuit.

Dans ces conditions, les signaux de commande des transistors interrupteurs T12 et T13 ne doivent pas être purement et simplement en opposition de phase, et donc ne peuvent pas être générés par des signaux d'horloge complémentaires, alors qu'il faut néanmoins que l'un des deux transistors T12 ou T13 soit non-passant quand l'autre transistor est passant.

En outre, du fait que ce circuit commutateur est utilisé dans un appareil mobile, les solutions faisant appel à plusieurs tensions de polarisation, en particulier négatives, ou/et à un grand nombre d'éléments additionnels doivent être évitées. Il est important qu'une seule batterie à tension positive standard puisse être utilisée pour fournir l'alimentation en continu du dispositif terminal mobile.

Selon l'invention, on utilise pour commander les transistors T12 et T13, d'une part la tension de polarisation $V_{TX}$ de l'amplificateur 40 de l'émetteur du signal TX, et on utilise d'autre part la tension de polarisation $V_{RX}$ de l'amplificateur 50 du récepteur du signal RX. Ces deux amplificateurs 40, 50 existent obligatoirement dans l'application décrite ici. Ces tensions de polarisation $V_{RX}$ et $V_{TX}$ sont positives et multiplexées en temps, par exemple par un microcontrôleur. La forme de ces tensions est représentée schématiquement ci-après en référence avec le chronogramme de la figure 2.

En référence avec la figure 2, on a représenté sur le chronogramme, d'une part le signal $V_{TX}$ et, d'autre part le signal $V_{RX}$ de polarisation des amplificateurs 40 et 50. Chacun de ces signaux $V_{TX}$ et $V_{RX}$ montre des impulsions de longueur T pendant lesquelles les tensions de polarisation correspondantes sont utilisées pour commander les transistors T12 et T13 et les rendre passants. Comme ces impulsions sont décalées, les transistors interrupteurs T12 et T13 ne sont pas passants en même temps. En outre, les impulsions de chaque signal $V_{TX}$ et $V_{RX}$ montrent des fronts de montée séparés d'une durée de temps T qui est grande devant la durée $\tau$ d'une impulsion. Par exemple, la durée $\tau$ d'une impulsion peut être 1/8 de la durée T qui sépare une impulsion de la suivante. Ainsi, il est possible, comme requis, de gérer 8 lignes ou utilisateurs de façon concomitante.

Ces tensions de polarisation $V_{TX}$ et $V_{RX}$ provenant des amplificateurs 40 et 50 de l'émetteur et du récepteur respectivement, sont associées aux éléments de circuit décrits ci-après pour constituer les tensions de commande des transistors interrupteurs T12, T13. Ces éléments comprennent :

- un pôle 22 pour la tension de polarisation $V_{TX}$ provenant de l'amplificateur d'émission 40,
- un pôle 23 pour la tension de polarisation $V_{RX}$ provenant de l'amplificateur de réception 50,
- un pôle 32 pour appliquer une tension de commande $V_{GS(T12)}$ sur la grille du transistor interrupteur T12,
- un pôle 33 pour appliquer une tension de commande $V_{GS(T13)}$ sur la grille du transistor interrupteur T13,
- un pôle 11 à l'extrémité de la résistance R1 opposé au premier pôle commun 1 relié à l'antenne A, pôle 11 référencé second pôle commun sur lequel on trouve une tension de polarisation $V_D$,
- une résistance R12 entre les pôles 22 et 32
- une résistance R13 entre les pôles 23 et 33
- une résistance R8 entre le pôle 11 et la masse,
- une diode $\Delta$12 entre les pôles 22 et 11
- une diode $\Delta$13 entre les pôles 23 et 11.

En référence avec la FIG.1A, les deux diodes $\Delta$12 et $\Delta$13, et la résistance R8 constituent un circuit logique 30 à diodes. Ce circuit logique 30 forme une porte logique "OU" utilisée dans le circuit commutateur 20 pour obtenir les tensions de commande appropriées pour être appliquées sur les électrodes de commande (grilles) des transistors T12, T13 au moyen des tensions de polarisation pulsées $V_{TX}$ et $V_{RX}$. La fonction "OU" est trouvée au noeud 11.

Le circuit commutateur 20 représenté sur la FIG.1B est favorablement réalisé en utilisant des transistors à effet de champ de type MESFET, dont la tension de pincement est négative, de l'ordre de -2V. Ces transistors MESFET sont normalement passants en l'absence de tension grille-source, ou pour une tension supérieure à la tension de pincement, et sont rendus non passants par une tension grille-source de valeur inférieure à la tension de pincement.

En outre, dans le circuit commutateur 20, les transistors à effet de champ T12 et T13 sont isolés en continu par les capacités C2, C3 placées aux entrées-sorties 12, 13 et par la capacité C1 placée entre le pôle commun 1 et l'antenne A. Ceci permet de rendre ces transistors flottants vis-à-vis de la masse et donc d'obtenir la tension négative nécessaire à leur pincement, à partir des tensions de polarisation multiplexées positives générées au moyen d'une tension de polarisation positive fournie par une batterie standard.

Le fonctionnement de ce circuit commutateur 20 est le suivant :

a) Lorsque la tension de polarisation $V_{TX}$ est présente au pôle 22, elle provoque une polarisation de la diode $\Delta$12. La chute de tension aux bornes de la diode est notée $V_\Delta$. La tension au pôle 11 est $V_D$ égale $V_{TX}$ moins la chute de tension $V_\Delta$ dans la diode $\Delta$12, c'est-à-dire $V_D = V_{TX} - V_\Delta$. Comme il ne circule aucun courant dans chacune des résistances R12, R13 de polarisation, la différence de potentiel entre le noeud 22 et le noeud 11 aux bornes de la diode $\Delta$12 du circuit logique 30 est donc reportée exactement entre le noeud 32 et le noeud 1, entre grille et source du transistor interrupteur T12. Donc la tension grille source du transistor T12 est :

$$V_{GS(T12)} = V_{TX} - (V_{TX} - V_\Delta) = V_\Delta.$$

La chute de tension aux bornes d'une diode réalisée au moyen de la même technologie que les transistors à effet de champ MESFET T12 et T13 est de l'ordre de :

$$V_\Delta \simeq 0,5 \text{ V}$$

d'où

$$V_{GS(T12)} \simeq 0.5 \text{ V}$$

ce qui rend ce transistor T12 passant.

Dans le cas où la tension de polarisation $V_{TX}$ est à l'état haut au pôle 12, du fait du multiplexage cité plus haut, obligatoirement $V_{RX}$ est à l'état bas au pôle 23. Dans ce cas, la tension grille-source du transistor T13 :

$$V_{GS(T13)} = -V_{TX} + V_\Delta$$

le transistor T13 est alors non-passant, la tension $V_{TX}$ étant de l'ordre de 3 à 6 V.

b) Lorsque la tension de polarisation $V_{RX}$ est présente au pôle 23, elle provoque alors la polarisation de la diode ∆13, et l'effet décrit en a) est inversé : le transistor interrupteur T13 devient passant, alors que le transistor interrupteur T12 est non-passant.

L'avantage de ce circuit commutateur 20 est que sont générées les tensions de commande appropriées pour les transistors interrupteurs T12 et T13, et que en même temps, la tension continue $V_D$ qui était nécessaire au pôle 11 est aussi générée. Ce circuit commutateur 20 n'utilise donc pas d'autres tensions d'alimentation que celles des amplificateurs 40 et 50 d'émission et réception déjà présentes.

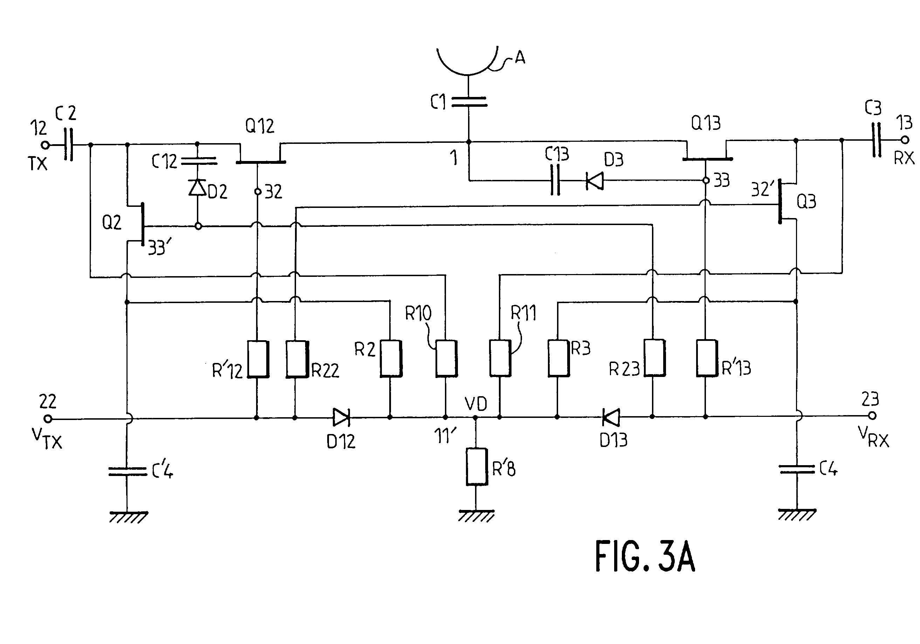

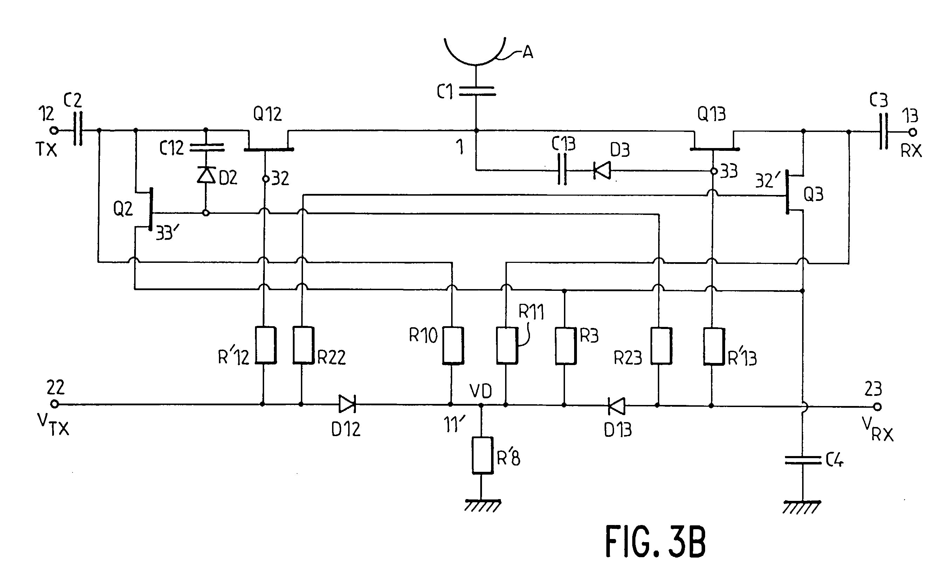

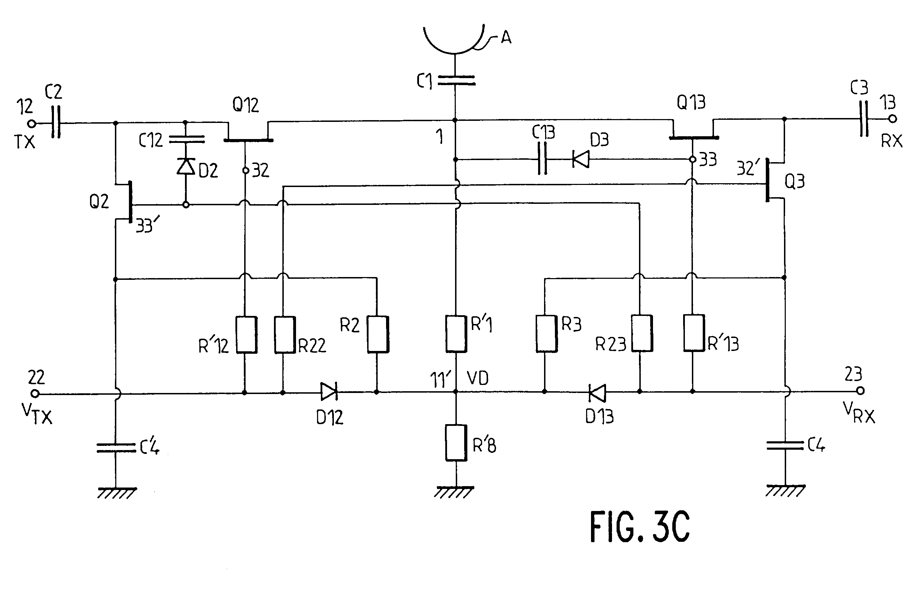

En référence avec les FIG.3A, 3B, 3C, dans un autre exemple, un circuit commutateur 20 comprend :

- un premier pôle 1 référencé premier pôle commun pour l'entrée ou la sortie d'un signal alternatif. Dans les exemples décrit ci-après, ce premier pôle d'entrée-sortie est relié à une antenne A.
- un second pôle 12 d'entrée, réservé à l'entrée d'un signal alternatif TX, provenant d'un émetteur 40 représenté schématiquement sur la FIG.4, et se propageant vers l'antenne A,
- un troisième pôle 13 de sortie réservé à la sortie d'un signal alternatif RX provenant de l'antenne et se propageant via ce pôle 13 vers un récepteur 50 représenté schématiquement sur la FIG.4,
- un transistor à effet de champ Q12, travaillant en interrupteur, monté en série entre le pôle commun 1 et le pôle d'entrée 12 du signal d'émission TX,
- un transistor à effet de champ Q13, travaillant en interrupteur, monté en série entre le pôle commun 1 et le pôle de sortie 13 du signal de réception RX,
- un signal de commande $V_{GS(Q12)}$ appliqué entre la grille et la source du transistor à effet de champ Q12 pour le rendre passant ou non-passant : lorsque le transistor interrupteur Q12 est passant le signal RX se propage du pôle d'entrée 12 vers l'antenne A.
- un signal de commande $V_{GS(Q13)}$ appliqué entre la grille et la source du transistor à effet de champ Q13 pour le rendre passant ou non-passant : lorsque le transistor interrupteur Q13 est passant le signal RX se propage du pôle commun 1 relié à l'antenne A vers le pôle de sortie 13.

Pour générer les tensions de commande $V_{GS(Q13)}$ et $V_{GS(Q12)}$ comme expliqué plus haut en relation avec la FIG.1B pour la génération des tensions de commande $V_{GS(T13)}$ et $V_{GS(T12)}$, le circuit commutateur 20 de ce deuxième exemple comprend en outre :

- un pôle 22 pour la tension de polarisation $V_{TX}$ provenant de l'amplificateur d'émission 40 (voir FIG.4),
- un pôle 23 pour la tension de polarisation $V_{RX}$ provenant de l'amplificateur de réception 50 (voir FIG. 4).
- un second pôle commun 11',
- une diode D13 entre le pôle d'entrée 23 de la tension de polarisation $V_{RX}$ et le second pôle commun 11',
- une diode D12 entre le pôle d'entrée 22 de la tension de polarisation $V_{TX}$ et le second pôle commun 11',
- le second pôle commun 11' relié à la masse à travers une résistance R'8,

Dans ce deuxième exemple illustré par les FIGS.3A, 3B, 3C, les diodes D12, D13 et la résistance R'8 constituent un circuit logique 30 à diodes à fonction "OU" comme celui de la FIG.1A. Les tensions présentes aux bornes des diodes D12, D13 sont reportées comme tensions de commande grille-source des transistors interrupteurs (transistors série) Q12, Q13 respectivement.

Ce circuit comprend en outre des transistors $Q_2$ et $Q_3$ montés en dérivation, le premier $Q_2$ entre le pôle d'entrée 12 et une résistance R2 ou R3, et le second $Q_3$ entre le pôle de sortie 13 et une résistance R3, l'autre extrémité des résistances R2 et/ou R3 étant reliée au second pôle commun 11'.

Le transistor Q3 monté en dérivation est commandé de la même façon que le transistor Q12 monté en série pour être passant en même temps. Le transistor Q2 monté en dérivation est commandé de la même façon que le transistor Q13 pour être passant en même temps.

Ce circuit comporte encore :

- des pôles 32 et 32' pour appliquer une tension de commande $V_{GS(Q12)}$ sur la grille des transistors série et dérivation Q12 et Q3 ; ces pôles 32 et 32' sont reliés respectivement au pôle 22 d'entrée du signal $V_{TX}$ de polarisation de l'amplificateur émetteur à travers des résistances R'12, R22,
- des pôles 33 et 33' pour appliquer une tension de commande $V_{GS(Q13)}$ sur la grille des transistors série et dérivation Q13 et Q2 ; ces pôles 33 et 33' sont reliés respectivement au pôle 23 d'entrée du signal

$V_{RX}$ de polarisation de l'amplificateur récepteur à travers des résistances R'13, R23,

Dans les mises en oeuvre illustrées par les FIGS.3A et 3B, ce circuit comprend également :

- une résistance R10 entre le second pôle commun 11' et l'entrée 12 du signal d'émetteur TX,
- une résistance R11 entre le second pôle commun 11' et la sortie 13 du signal de récepteur RX,

Dans une mise en oeuvre particulière illustrée par la FIG.3C, le pôle 11' est relié au pôle 1 à travers une résistance R'1, et dans ce cas les liaisons par les résistances R10 et R11 montrées sur les FIG.3A et 3B sont supprimées.

Dans les mises en oeuvre illustrés par les FIG.3A et 3C, les sources des transistors en dérivation Q2 et Q3 ne sont pas communes, mais sont reliées respectivement au second pôle commun 11' par les résistances R2 et R3, et sont reliées respectivement à la masse par les capacités C'4 et C4.

Dans la mise en oeuvre illustré par la FIG.3B, les sources des transistors en dérivation $Q_2$ et $Q_3$ sont communes et reliées au pôle 11' par la seule résistance R3 et à la masse à travers une seule capacité C4.

Le système formé par les transistors $Q_2$ et $Q_3$ en dérivation, et leurs moyens de polarisation permet d'éliminer les courants de fuite résiduels des transistors en série Q12 et Q13 à l'état non passant.

Une amélioration supplémentaire est constituée par :

- des diodes D3 et D2 montées respectivement entre le pôle 33 de grille du transistor série Q13 et le pôle commun 1, et entre le pôle 33' de grille du transistor en dérivation Q2 et l'entrée 12 du signal d'émetteur TX.

Ces systèmes formés respectivement d'une diode et d'une capacité, permettent d'augmenter la puissance transmise dans les transistors en série Q12, Q13, sans déformation des signaux alternatifs TX et RX. En effet, dans le cas où on utilise ces systèmes, la grille des transistors Q12, Q13 suit la valeur maximale du signal alternatif venant du pôle 12 ou se propageant vers le pôle 13, par détection au moyen des diodes D2 et D3.

Le circuit commutateur 20 proposé dans ce deuxième exemple illustré par les FIG.3A, 3B, 3C, tire avantage de l'utilisation de transistors à effet de champ du type MESFET ayant une tension de pincement négative de l'ordre de - 2 V, et peut néanmoins opérer avec une tension d'alimentation positive basse par batterie standard de l'ordre de 3 à 6 V. Ce circuit commutateur ne nécessite pas de tension d'alimentation propre. Cette tension d'alimentation qui se serait trouvée au point commun 1 d'antenne n'a pas lieu d'être fournie d'une manière indépendante par une batterie dans le présent circuit commutateur.

Les tensions de commandes appropriées pour les transistors interrupteurs Q12 et Q3 d'une part, et Q13 et Q2 d'autre part, sont générées à partir des tensions de polarisation $V_{TX}$ et $V_{RX}$ déjà obligatoirement présentes dans les circuits amplificateurs 40 et 50 du circuit émetteur et du circuit récepteur réprésentés sur la FIG.4. Ces tensions de polarisation sont en outre déjà multiplexées en temps, c'est-à-dire décalées cycliquement, en relation avec le chronogramme de la figure 2, et leur utilisation est donc particulièrement avantageuse.

Comme les tensions de polarisation $V_{TX}$ et $V_{RX}$ ne sont jamais à l'état 1 en même temps, c'est-à-dire jamais présentes en même temps, le circuit des FIGS. 3 ne peut présenter que les états de fonctionnement suivants.

A) Lorsque $V_{TX}$ est à l'état 1, les transistors Q12 et Q3 deviennent passants et le signal alternatif TX est propagé vers l'antenne. Durant ce temps $V_{RX}$ est à l'état 0 et les transistors Q13 et Q2 sont non-passants.

B) Lorsque $V_{TX}$ est à l'état 0, les transistors Q12 et Q3 sont non-passants et le signal alternatif TX ne se propage pas, mais pendant ce temps $V_{RX}$ est à l'état 1, d'où il résulte que les transistors Q13 et Q2 sont passants et que le signal alternatif RX se propage de l'antenne A vers le pôle 13.

Durant l'état A), les transistors Q12 et Q3 sont passants parce que leurs tensions grille-source $V_{GS(Q12)}$ et $V_{GS(Q3)}$ égalent la tension de chute, environ 0,5 à 0,7 V dans la diode D13 qui est à ce moment-là rendue conductrice. Cette chute de tension $V_\Delta$ dans la diode a un niveau suffisant pour rendre ces transistors passants.

Au même moment, les transistors Q13 et Q2 sont non-passants parce que leurs tensions grille-source $V_{GS(Q13)}$ et $V_{GS(Q2)}$ égalent la chute de tension, 0,5 à 0,7 dans la diode D13 moins la tension $V_{TX}$ qui est de l'ordre de 3 à 6 V. Cette tension est donc suffisamment négative pour maintenir les transistors non-passants.

Durant l'état B), la situation est purement inversée.

Pour réaliser le circuit selon l'invention, on peut utiliser des éléments ayant les valeurs suivantes :

R'12 = 2 kΩ        R22 = 2 kΩ

R2 = 2 kΩ        R'8 = 2 kΩ.

Tous les transistors à effet de champ Q12, Q13, Q2, Q3 montés en interrupteurs sont rendus flottants par des capacités d'isolation en continu : C2 et C3 montées aux pôles d'entrée-sortie 12 et 13, C1 montée entre le pôle commun 1 et l'antenne A, C4 montée entre les sources communes des transistors Q2 et Q3 et la masse (FIG.3B), et C4, C'4 montées entre les sources non communes des transistors Q2 et Q3 et la masse (FIG.3A et FIG.3C). Les valeurs de ces capacités peuvent être de l'ordre de 100 pF. Ce montage flottant permet d'obtenir les tensions de commande négatives des transistors à partir des tensions de polarisation positives.

En référence avec la FIG.4, le circuit commutateur (20) est représenté utilisé dans un terminal 100 de télécommunication mobile.

Cet appareil peut comprendre :

-    un microphone 80,
-    un amplificateur émetteur 40, utilisant une tension de polarisation pulsée $V_{TX}$ disponible au pôle 22, et fournissant un signal alternatif TX à sa sortie 12,
-    un circuit commutateur 20, relié à l'antenne A au pôle 1 comprenant deux interrupteurs T12 et T13 (ou Q12 et Q13) montés en série de part et d'autre du pôle commun 1 ; ce circuit commutateur incluant un circuit logique à fonction "OU" 30 à diodes $\Delta$12, $\Delta$13 (ou D12, D13) et résistance R8 ou R'8 ; ce circuit commutateur 20 ayant une entrée 12 pour le signal TX, une entrée/sortie 1 pour l'antenne A, une sortie 13 pur un signal alternatif RX, une entrée 22 pour le signal pulsé de polarisation $V_{TX}$, et une entrée 23 pour un signal pulsé de polarisation $V_{RX}$ ;
-    un amplificateur récepteur 50, utilisant une tension de polarisation pulsée $V_{RX}$ disponible au pôle 23 pour l'utilisation par le circuit commutateur 20, et recevant de ce dernier au pôle 13 la tension alternative RX.
-    un haut parleur 90.

Ce dispositif comprend en outre différents circuits tels que des convertisseurs analogique-numérique, ou numérique-analogique, des codeur et décodeur, des adaptateurs etc... représentés symboliquement par le bloc 60 entre le microphone 80 et l'amplificateur 40, et le bloc 70 entre l'amplificateur 50 et le haut parleur 90.

Ces circuits peuvent être de types connus de l'homme du métier et ne sont pas décrits plus avant.

Ce dispositif 100 peut être utilisé à titre d'exemple dans des systèmes à terminaux mobiles de types actuellement référencés en télécommunication :

GSM 900 (en anglais Global System for Mobile for 900 MHz)
DCS 1800 (en anglais Digital Communication System for 1800 MHz)

Le protocole de fonctionnement de ces systèmes est du type référencé TDMA (en anglais Time Division Multiple Access). Dans ce protocole, les tensions d'alimentation fournies par batteries positives de 3 à 6 V sont générées sous forme pulsée, montrée sur la FIG. 2, par exemple par un microcontrôleur. L'utilisation des systèmes de télécommunication par plusieurs utilisateurs de façon concomitante est gérée par des bornes (ou bases) réparties géographiquement sur un territoire, pour que leur rayon d'action couvre ce territoire.

## Revendications

**1.**  Dispositif terminal mobile pour télécommunication comprenant:

une antenne (A) d'émission-réception,
une partie (40,60,80) pour l'émission de données, incluant un circuit amplificateur émetteur (40) ayant une première tension de polarisation pulsée ($V_{TX}$) et fournissant un premier signal alternatif (TX) à un pôle d'entrée (12),
une partie (50,70,90) pour la réception de données, incluant un circuit amplificateur récepteur (50) ayant une seconde tension de polarisation pulsée ($V_{RX}$) multiplexée dans le temps avec la première tension de polarisation ($V_{TX}$) et recevant un second signal alternatif (RX) d'un pôle de sortie (13),
un circuit commutateur (20) comprenant un premier et un second transistors à effet de champ (T12,Q12;T13,Q13) montés en interrupteurs et disposés en série entre ledit pôle d'entrée (12) et ledit pôle de sortie (13), et ayant un pôle commun (1) connecté à l'antenne (A),
un circuit logique OU (30) formé d'une première et d'une seconde diodes ($\Delta$12, $\Delta$13 ; D12, D13) ayant un pôle commun (11,11'), relié à la masse à travers une résistance (R8), lesdites diodes recevant respectivement la première et la seconde tensions de polarisation ($V_{TX}$,$V_{RX}$) multiplexées, de manière que, aux bornes (22,11,11';23,11,11') de ces diodes, sont prélevées respectivement une première et une seconde différences de potentiel pulsées multiplexées, appliquées entre les électrodes de commande (32,33) des premier et second transistors interrupteurs (T12,Q12;T13,Q13) et le pôle commun à l'antenne à travers des résistances de polarisation (R12,R13,R1; R'12,R'13,R'1;R'12,R10,R11), pour rendre passant le premier transistor interrupteur (T12, Q12) et en même temps non-passant le second transistor interrupteur (T13, Q13), ou vice versa.

**2.**  Dispositif selon la revendication 1, comprenant des capacités d'isolation en continu (C1,C2,C3) montées entre l'antenne et le pôle commun (1) aux transistors interrupteurs,et entre les pôles d'entrée et sortie (12,13) des amplificateurs (40,50) respectivement d'émission et réception et le circuit commutateur (20), pour rendre ce circuit commutateur (20) flottant vis-à-vis de la masse.

3. Dispositif selon l'une des revendications 1 ou 2, dans lequel le circuit commutateur (20) comprend en outre un premier et un second transistors à effet de champ (Q2, Q3) montés en dérivation respectivement entre lesdits pôle d'entrée (12) et pôle de sortie (13) et le pôle commun (11') aux diodes, ces transistors étant montés en interrupteurs et commandés respectivement par les signaux de commande du second transistor monté en série (Q13) et du premier transistor monté en série (Q12), ces signaux de commande étant réglés par le circuit logique OU (30) à diodes à partir des tensions de polarisation pulsées multiplexées ($V_{TX}$, $V_{RX}$) provenant des circuits amplificateurs (40, 50) émetteur et récepteur.

4. Dispositif selon la revendication 3, dans lequel le circuit commutateur comprend des branches formées d'une diode (D2, D3) et d'une capacité d'isolation en continu (C12, C13) reliant respectivement l'électrode de commande du premier transistor en dérivation (Q2) et ledit pôle d'entrée (12), et l'électrode de commande du second transistor série (Q13) et le pôle commun connecté à l'antenne (1).

5. Dispositif selon l'une des revendications 3 ou 4, dans lequel le circuit commutateur comprend des capacités (C4) d'isolation en continu disposées entre la borne commune des transistors en dérivation (Q2,Q3) et la masse, pour rendre ces transistors flottants vis-à-vis de la masse.

6. Dispositif selon l'une des revendications 1 à 5, dans lequel les transistors à effet de champ du circuit commutateur sont du type à tension de pincement négative.

7. Dispositif selon l'une des revendications 1 à 6, comprenant en outre un microphone (80) ayant des moyens de liaison (60) à l'amplificateur émetteur (40), et un haut-parleur (90) ayant des moyens de liaison (70) à l'amplificateur récepteur (50).

**Patentansprüche**

1. Mobilfunkgerät, das enthält:

    Eine Sende-Empfangs-Antenne (A),
    ein Teil (40,60,80) für die Datenübertragung mit einer Sendeverstärkerschaltung (40), die eine erste Impuls-Polarisationsspannung ($V_{TX}$) hat und ein erstes Wechselsignal (TX) an einen Eingangspol (12) liefert,

    ein Teil (50,70,90) für den Datenempfang mit einer Empfangsverstärkerschaltung (50), die eine zweite Impuls-Polarisationsspannung ($V_{RX}$) im Zeitmultiplex mit der ersten Polarisationsspannung ($V_{TX}$) hat und ein zweites Wechselsignal (RX) von einem Ausgangspol (13) erhält,
    einen Schaltkreis (20) mit einem ersten und einem zweiten Feldeffekttransistor (T12,Q12; T13,Q13), als Unterbrecher geschaltet und in Serie angeordnet, zwischen dem besagten Eingangspol (12) und dem besagten Ausgangspol (13), und mit einem gemeinsamen, an die Antenne (A) angeschlossenen Pol (1),
    Eine logische ODER-Schaltung (30), gebildet aus einer ersten und einer zweiten Diode (Δ12, Δ13; D12, D13) mit einem gemeinsamen Pol (11, 11'), über einen Widerstand (R8) mit der Masse verbunden, wobei die besagten Dioden jeweils die erste und zweite Multiplex-Polarisationsspannung ($V_{TX}$, $V_{RX}$) erhalten, damit an den Klemmen (22,11,11';23,11,11') dieser Dioden jeweils eine erste und eine zweite Impuls-Multiplex-Potentialdifferenz entnommen wird, zwischen den Steuerelektroden (32,33) des ersten und zweiten Unterbrechertransistors (T12,Q12;T13,Q13) und dem gemeinsamen Pol über Polarisationswiderstände (R12,R13,R1;R'12,R'13,R'1;R'12,R10,R11) der Antenne zugeführt, um den ersten Steuertransistor (T12, Q12) leitend und zugleich den zweiten Unterbrechertransistor (T13, Q13) nichtleitend zu machen oder umgekehrt.

2. Gerät nach Anspruch 1, mit Gleichstrom-Isolationskapazitäten (C1,C2,C3), zwischen der Antenne und dem gemeinsamen Pol (1) der Unterbrechertransistoren und zwischen den Eingangs- und Ausgangspolen (12,13) jeweils der Sende- und Empfangsverstärker (40,50) und dem Schaltkreis (20) angeordnet, um diesen Schaltkreis (20) gegenüber der Masse driftend zu machen.

3. Gerät nach einem der Ansprüche 1 oder 2, in dem der Schaltkreis (20) zudem einen ersten und einen zweiten Feldeffekttransistor (Q2, Q3) enthält, zwischen dem besagten Eingangspol (12) und dem Ausgangspol (13) und dem gemeinsamen Pol (11') zu den Dioden jeweils parallel geschaltet, wobei diese Transistoren als Unterbrecher geschaltet und jeweils von den Steuersignalen des zweiten in Serie geschalteten Transistors (Q13) und des ersten in Serie geschalteten Transistors (Q12) gesteuert werden und diese Steuersignale von der logischen ODER-Diodenschaltung (30) anhand der Impuls-Multiplex-Polarisationsspannungen ($V_{TX}$, $V_{RX}$) aus den Sende- und Empfangsverstärkerschaltungen (40, 50) geregelt werden.

**4.** Gerät nach Anspruch 3, in dem der besagte Schaltkreis Zweige enthält, gebildet aus einer Diode (D2, D3) und einer Gleichstrom Isolationskapazität (C12, C13), die jeweils die Steuerelektrode des ersten parallelen Transistors (Q2) und den besagten Eingangspol (12), und die Steuerelektrode des zweiten Transistors in Serie (Q13) und den gemeinsamen, an die Antenne (1) angeschlossenen Pol miteinander verbinden.

**5.** Gerät nach einem der Ansprüche 3 oder 4, in dem der Schaltkreis Gleichstrom-Isolationskapazitäten (C4) enthält, zwischen der gemeinsamen Klemme der parallelen Transistoren (Q2,Q3) und der Masse angeordnet, um diese Transistoren gegenüber der Masse driftend zu machen.

**6.** Gerät nach einem der Ansprüche 1 bis 5, in dem die Feldeffekttransistoren des Schaltkreises vom Typ negativer Pinch-off-Spannung sind.

**7.** Gerät nach einem der Ansprüche 1 bis 6, mit zudem einem Mikrophon (80), das Verbindungsmittel (60) zum Sendeverstärker (40) hat, und einem Lautsprecher (90), das Verbindungsmittel (60) zum Empfangsverstärker (50) hat.

**Claims**

**1.** A mobile terminal device for telecommunications, comprising:

> a transceiving aerial (A),
> a section (40,60,80) for data transmission, including a transmitting amplifier (40) which has a first pulsed bias voltage ($V_{TX}$) and applies a first AC signal (TX) to an input terminal (12),
> a section (50,70,90) for data reception, including a receiving amplifier (50) which has a second, time-division multiplexed pulsed bias voltage ($V_{RX}$) and receives a second AC signal (RX) from an output terminal (13),
> a switch circuit (20) including a first and a second field effect transistor (T12,Q12;T13,Q13) arranged as switching transistors connected in series between said input terminal (12) and said output terminal (13) which switching transistors have a common terminal (1) connected to the aerial (A),
> a logic OR circuit (30) formed by a first and a second diode ($\Delta$12,$\Delta$13;D12,D13) which have a common terminal (1), which circuit is connected to ground via a resistor (R8), which diodes receive the first and the second multiplexed bias voltage ($V_{TX}$,$V_{RX}$) respectively, so that at the terminals (22,11,11';23,11,11') of these diodes are obtained a first and a second multiplexed pulsed voltage difference applied between the control electrodes (32,33) of the first and second switching transistors (T12,Q12;T13,Q13) and the common terminal connected to the aerial via bias resistors (R12,R13,R1; R'12,R'13,R'1;R'12,R10,R11), to render the first switching transistor (T12,Q12) conductive and, at the same time, cut off the second switching transistor (T13,Q13).

**2.** A device as claimed in Claim 1, comprising DC-isolating capacitors (C1,C2,C3) connected between the aerial and the common terminal (1) of the switching transistors, and between the input and output terminals (12,13) of the transmitting and receiving amplifiers (40,50) respectively and the switch circuit (20), to make this switch circuit (20) floating relative to ground.

**3.** A device as claimed in one of the Claims 1 or 2, in which the switch circuit (20) further includes a first and a second field effect transistor (Q2, Q3) arranged in the shunt mode between respectively the input terminal (12), the output terminal (13) and the common terminal (11') of the diodes, while these transistors are arranged as switching transistors and controlled, respectively, by the control signals of the second series-connected transistor (Q13) and of the first series-connected transistor (Q12), these control signals being controlled by the logic OR circuit (30) based on multiplexed pulsed supply voltages ($V_{TX}$, $V_{RX}$) coming from the transmitting amplifier circuit (40) and the receiving amplifier circuit (50).

**4.** A device as claimed in Claim 3, in which the switch circuit includes branches formed by a diode (D2, D3) and a DC-isolating capacitor (C12, C13) connecting, respectively, the control electrode of the first shunt transistor (Q2) and the input terminal (12), and the control electrode of the second series-connected transistor (Q13) and the common terminal connected to the aerial (1).

**5.** A device as claimed in one of the Claims 3 or 4, in which the switch circuit includes DC isolating capacitors (C4,C'4) connected between the common terminal of the shunt transistors (Q2,Q3) and ground to render these transistors floating relative to ground.

**6.** A device as claimed in one of the Claims 1 to 5, in which the field effect transistors of the switch circuit are of the negative cut-off voltage type.

**7.** A device as claimed in one of the Claims 1 to 6, further including a microphone (80) which has connecting means (60) for connecting to the transmitting amplifier (40), and a loudspeaker (90) which has connecting means (70) for connecting to the receiving amplifier (50).

FIG. 1A

FIG. 1B

FIG. 2

FIG. 3A

FIG.3B

FIG. 3C

EP 0 720 292 B1

FIG. 4